# EUROPEAN PATENT SPECIFICATION

(11) **EP 2 111 479 B1**
(45) Date of publication and mention of the grant of the patent: **27.04.2011**
(21) Application number: 08701597.0
(22) Date of filing: 18.01.2008
(51) Int. Cl.: C23C 14/50, G02B 7/02

(54) **OPTICAL LENS HOLDER**
HALTER FÜR EINE OPTISCHE LINSE
PORTOIR POUR LENTILLE OPTIQUE

(30) Priority: 25.01.2007 EP 07290104
(43) Date of publication of application: 28.10.2009
(73) Proprietor: Essilor International (Compagnie Générale D'Optique), 94220 Charenton le Pont (FR)
(72) Inventor: RYCHEL, Dominique, F-94220 Charenton-le-Pont (FR); WILLEMIN, Gérard, F-94220 Charenton-le-Pont (FR); NOUVELOT, Luc, F-94220 Charenton-le-Pont (FR); DE AYGUAVIVES, Francisco, F-94220 Charenton-le-Pont (FR)
(74) Representative: Cabinet Plasseraud
(86) International application number: PCT/EP2008/050593
(87) International publication number: WO 2008/090101

(56) References cited:
- EP-A- 0 992 607
- EP-A1- 0 406 484
- WO-A-95/05494
- GB-A- 2 244 286
- JP-A- 2002 097 572
- JP-A- 2003 029 112
- US-A- 5 514 214

## Description

The invention which is the subject of this application relates to an improved device to be used in holding an optical lens in a required position during the application of a coating thereon. The invention is particularly, but not exclusively, directed towards the provision of a holder for use in holding an optical lens in a sputter coating chamber and by which process a coating can be applied to the surfaces of the optical lens.

The use of sputter coating techniques to apply coatings to optical lenses, is well known. A common problem encountered when applying coatings is that not all of the sputtered material is applied to the exposed optical lens surface and excess material is applied to other surfaces in the coating chamber. This is not a major problem when the optical lenses are flat but, when the optical lenses are curved such as for example optical lens which have a concave and convex surface, and a material or materials are being sputtered on one of the surfaces, say the exposed concave surface, then the excess or back scattered sputtered material can be deposited on the other of the surfaces which in this case is the convex surface of the optical lens. This deposition causes surface irregularities which, when a layer of material is to be sputter deposited on the same can clause problems with the adherence of the layer to the surface.

EP 714454 discloses the provision of masking means which allow the prevention of back scattered material from reaching the surface which is not being coated at that time.

EP 0992607 discloses a holder which provides an improvement to the masking technique and includes the same in the holder where the optical lens holder for use to support an optical lens during the deposition of a material to form a coating on at least one surface of the optical lens using a material deposition technique, comprises a housing, a support for the optical lens within the housing, the housing having an opening with which an annular retaining ring is engageable and the support biased towards said retaining ring so as to trap the optical lens in position between the retaining ring and support with at least a portion of a surface of the optical lens exposed for the application of material thereon.

EP 0 992 607 discloses a substrate holder which can be used to support and protect a substrate during the application of material by deposition technique and which is provided with a retaining ring.

Typically the ring is an annulus, typically only slightly smaller than the outer edge of the optical lens so that it is effectively the edge of the optical lens which is trapped by the support and the ring and the remainder of the optical lens surface facing the ring is exposed for the application of material thereto. In one embodiment the retaining ring includes a rim which protrudes inwardly of the aperture at the edge of same facing the material deposition means and it is the rim which defines the size of the ring aperture to be slightly less than the optical lens and which contacts with the edge of the optical lens to provide the same in sealed engagement thereby preventing the passage of deposited material over the line of seal and into the housing, so preventing the deposition of material onto other surfaces of the optical lens. In one embodiment, for ease of use, the retaining ring is engageable on the housing by using bayonet engagement means.

However the inventors have noticed that the optical quality of coated optical lenses was not fully satisfactory when using the holder disclosed in EP 0992607. Cosmetic defects are frequently noticed such as light diffusing rings which can be seen when watching the coated optical lenses in transmission. Some defects are also noticed when watching the optical lens in reflexion in an area corresponding to previous light diffusing rings.

As for an example, 70 mm diameter optical lenses of different add power (0 Diopter and 6 Diopter add power) have been coated using the holder disclosed in EP 0992607. About 60% of the coated optical lenses show light diffusing rings situated in a zone where contacting members of the holder press onto the optical lenses. Standard control procedures were used to watch said coated optical lenses.

Accordingly there remains a need for improving the optical quality of coated optical lenses and for improving the holder disclosed in EP 0992607.

Thus, the goal of the present invention is to improve the previous optical lens holder and related coating method to enhance the optical quality of resulting coated optical lenses.

This object is obtained according to the invention by an optical lens holder for supporting an optical lens during the deposition of a material to form a coating on at least one surface of the optical lens using a material deposition technique, where the optical lens holder comprises a housing, a support for the optical lens within the housing comprising first contacting members within a first diameter D₁, the housing having an opening with which a retaining ring, comprising second contacting members outer of a second diameter D₂ greater than first diameter D₁, is engageable and said support biased towards said retaining ring so as to press and trap the optical lens in position between the retaining ring and support with at least a portion of a surface of the optical lens exposed for the application of material thereon, where an intermediate part is located between the first optical lens contacting members and the optical lens so as to avoid substantially bending of the optical lens.

Every means suitable for substantially avoiding bending of the optical lens may used to implement the present invention.

According to the present invention, it is considered that there is no substantial bending of the optical lens for example when the contacting zone between the optical lens and the intermediate part is situated on a diameter greater or equal to D₂ or for example when the contacting zone between the optical lens and the intermediate part covers a zone which external diameter is greater than D₁ and where the contacting surface is large enough to distribute the pressing force on almost all the internal surface of the optical lens. According to the invention "almost all the surface" means at least 80% of the surface, for example at least 90% of the surface.

When the contacting zone between the optical lens and the intermediate part is situated on a diameter greater or equal to D₂, no bending strain occurs in the optical lens because the optical lens is pressed between first and second contacting members on the external periphery of the optical lens only.

When the contacting zone between the optical lens and the intermediate part is a zone which external diameter is greater than D₁ and contacting surface is large enough to distribute the pressing force on almost all the internal surface of the optical lens, the internal surface of the optical lens fits the intermediate part on almost all its internal surface and resulting bending strains are low, and dramatically reduced when compared to bending strains resulting of a direct contact between the first contacting members and the optical lens.

The inventors have observed that using such an optical lens holder reduces significantly the optical defects, namely light diffusing rings and reflexion defects, and even eliminates them completely.

Without being bound by any theory, the inventors think that the holder of the invention advantageously lowers significantly the bending strains within the optical lens thanks to the contact of the optical lens with the intermediate part and avoid direct contact of the optical lens with the first contacting members of the holder, thus improving optical quality of the resulting optical lens.

According to the present invention, the wordings "internal", "external" indicate positions relative to the surface of the optical lens to be coated on where said surface is referred as the "external" surface and where the opposite surface is the "internal" one. Accordingly, the optical lens contacting zone of the first contacting members is an internal one and the optical lens contacting zone of the second contacting members is an external one.

According to the present invention, the wordings "inner", "outer" indicate positions relative to the inward periphery of the optical lens external surface continuously contacting zone of the second contacting members. An "inner" part is defined as being situated inwardly said contacting zone and an outer part as being situated outwardly said contacting zone.

A reference axis is determined as being located perpendicularly to a reference plane including the inward periphery of the optical lens external surface continuously contacting zone of the second contacting members and intercepting the geometrical centre of said periphery.

Said periphery is usually a circle, its geometrical centre is then the centre of said circle and the reference axis is a revolution axis.

First diameter D₁ is defined as being the diameter of a circle situated at the outwards limit of the periphery of the optical lens internal surface contacting zone of the first contacting members, in a plane parallel to the reference plane and a centre on the reference axis. When the second contacting members have a circular shape, the diameter of the outer optical lens contacting circle is D₁.

Second diameter D₂ is defined as being the diameter of a circle situated at the inwards limit of the periphery of the optical lens external contacting zone of the second contacting members, in a plane parallel to the reference plane and a centre on the reference axis. When the first contacting members have a circular shape, the diameter of the inner optical lens contacting circle is D₂.

The optical lens can be placed vertically and the reference plane is then a vertical plane.

According to an embodiment of the invention, the support comprises a plate with a circular rim as the first contacting members which external diameter is equal to the first diameter D₁.

According to a further embodiment, the second contacting members are a circular rim which internal diameter is equal to the second diameter D₂ and which protrudes inwardly towards the optical lens at an inner edge of the aperture defined by the ring and defines the area of the optical lens surface which is exposed for the application of material thereon.

According to an embodiment of the invention, the intermediate part is a substantially rigid plate which external periphery substantially fits the internal periphery of the second contacting member.

Said plate may be a two-part plate in which a first part substantially fits the internal periphery of the second contacting members and a second part fits the internal periphery of the rim of the first contacting member.

According to an embodiment of the invention, the intermediate part contacts the optical lens in a contacting zone situated on a diameter greater or equal to the second diameter D2.

According to another embodiment of the invention, the intermediate part is a bed comprising at least a surface of external diameter greater than the first diameter D₁ which fits a surface of the optical lens to be coated on and a surface adapted to contact the first contacting members.

Said both surfaces may fit both surfaces of the optical lens to be coated on.

According to an embodiment, the intermediate part is a polycarbonate shell.

According to an embodiment of the invention, the intermediate part contacts the optical lens on a contacting surface of at least 80% of the internal surface of the optical lens.

The invention relates also to a method for applying a coating to at least one surface of an optical lens using a material deposition technique, said method including the steps of placing the optical lens in an optical lens holder, where said comprising first contacting members within a first diameter D₁, on which the optical lens is placed, said support biased to urge the optical lens towards an opening defined by a retaining ring comprising second contacting members outer of a second diameter D₂ greater than D₁, said optical lens trapped between the support and retaining ring with the surface to be coated exposed to the material deposition means to allow the layer on the surface to be formed by the deposition of material thereon and the remaining surfaces of the optical lens sealed by the retaining ring to minimise the passage of deposited material onto said other surfaces, characterized in that an intermediate part is placed between the first contracting members and the optical lens so as to avoid substantially bending of the optical lens.

According to an embodiment of said method, the surface of the optical lens to be coated on is the convex surface, a rigid plate which external periphery substantially fits the internal periphery of the second contacting members is the intermediate part and the external periphery of the concave surface of the optical lens contacts the rigid plate.

According to an embodiment of the method of the invention, the surface of the optical lens to be coated on is the convex surface, and the intermediate part contacts the optical lens in a contacting zone situated on a diameter greater than the second diameter D2.

According to another embodiment of said method, the surface of the optical lens to be coated on is either the concave in the convex surface of the optical lens, and a bed comprising at least a surface of external diameter greater than the first diameter D₁ surface of the optical lens and a surface adapted to contact the first contacting members is the intermediate part.

According to an embodiment, the intermediate part is a polycarbonate shell.

According to an embodiment of the method of the invention, the intermediate part contacts the optical lens on a contacting surface of at least 80% of the internal surface of the optical lens.

Non limiting embodiments of the invention will now be described with reference to the accompanying drawings wherein:
Figures 1 and 2 illustrate a cross sectional view of the holder following two embodiments according to the present invention where the surface of the optical lens to be coated on is the convex surface.
Figure 3 illustrates a cross sectional view of the holder following an embodiment according to the present invention where the surface of the optical lens to be coated on is the concave surface.

The lens 32 is placed vertically in the holder.

The holder presents a revolution of symmetry according to axis 40.

The holder comprises a housing 4, a retaining ring 6 and an optical lens support means 8. The housing includes a locating means 10 to allow the holder to be loaded and located on a carrier, not shown, which allows a number of said holders to be rotated during sputter deposition of material or materials to form coatings on optical lenses held in the holders. The apparatus used for applying the material can be of any known form, but preferred embodiments of apparatus are disclosed in the applications derived from PCT/GB92/00071 and PCT/GB95/00580.

The support means 8 comprises a plate 12 with a rim 14. The outer diameter of the rim 14 is D₁. The plate and rim are mounted on a member 16 which is movable in relation to the housing and through an aperture in the same. The movement of the member causes movement of the plate 12 and rim 14. The position of the plate and rim is biased by a spring 20 which acts to move the plate and rim to an extended or normal position which is beyond the opening 22 of the housing.

According to prior art EP 0 992 607, the optical lens 32 to be coated on contacts directly the rim 14. The spring 20 makes said rim 14 press on the internal surface of the optical lens 32. Rubbing and/or abrasion and/or bending of the optical lens may occur in the contacting zone. Inventors have noticed that resulting coated optical lenses have poor optical quality and that light diffusing rings can be seen in a zone where first contacting members 14 press onto the optical lens.

According to the present invention, an intermediate part 7, 70, 9 is placed between the rim 14 and the optical lens to be coated.

The retaining ring comprises an aperture defined by an inner wall 28 which has a rim 30 depending inwardly therefrom. The inner diameter of the rim 30 is D₂. The inner wall is larger than the optical lens optical lens 32 and the optical lens passes through the aperture to contact with the rim 30. The outer wall 31 of the ring is stepped as shown and includes in conjunction with the inner wall of the housing 4 at the opening 22, bayonet fittings 34 which allow engagement of the ring with the housing. This means that when the optical lens is in position on the intermediate part 7, 70, 9, and said intermediate part is in position on the support 8 and forced by the support under the action of the spring 20 against the retaining ring in position in the housing, the housing opening 22 is completely sealed. The ability to seal the housing opening prevents any sputtered material from entering the same.

In use therefore, the optical lens 32 has a concave surface 36 and a convex surface 38.

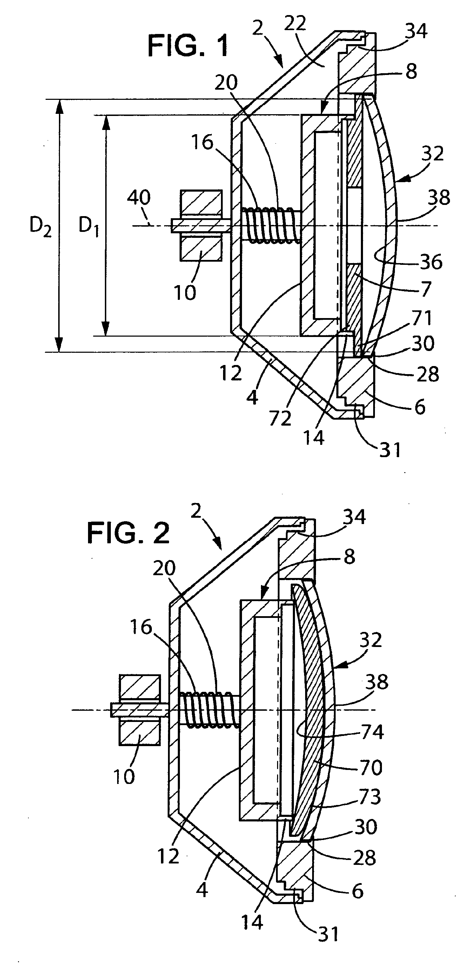

To coat the convex surface 38 of the optical lens, the optical lens is placed on the intermediate part 7, 70 with the concave surface contacting the intermediate part 7, 70 and said intermediate plate is placed on the support 8 as shown in Figure 1 or 2. With the optical lens in position, the retaining ring is moved into location on the housing and the optical lens is then trapped between the rim 30 on the retaining ring and the support 8. This therefore means that substantially the entire convex surface of the optical lens is exposed for the sputter deposition of material thereon to form the coating without substantially bending the optical lens..

Examples of two intermediate parts used to coat the convex surface 38 of the optical lens are illustrated in Figures 1 and 2.

The intermediate part of Figure 1 is a circular rigid plate 7. The outer part of the internal surface of the optical lens 32 contacts said plate 7 at its external periphery. Plate 7 is a two-part plate where a first circular part 71 substantially fits the internal periphery of the second contacting members 30 and a second circular part 72 fits the internal periphery of the rim 14 of the first contacting members. The lens 32 is then held without being bent.

The intermediate part of Figure 2 is a bed 70 with a convex surface 73 and a concave surface 74. The convex surface 73 substantially fits the whole internal surface of the optical lens 32 when the housing opening is sealed. The concave surface 74 contacts the rim 14 of the first contacting members. Resulting bending strains are then significantly lowered compared to prior art.

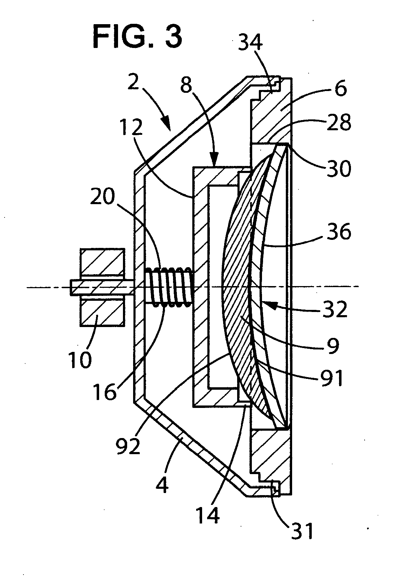

To coat the concave surface 36, the optical lens is placed on the intermediate part 9 with the convex surface contacting the intermediate part 9 and said intermediate part is placed on the support 8 as shown in Figure 3.

Said intermediate part 9 is a bed with a convex surface 92 and a concave surface 91. The concave surface 91 substantially fits the whole internal surface of the optical lens 32 when the housing opening is sealed. The convex surface 92 contacts the rim 14 of the first contacting members. Resulting bending strains are then significantly lowered compared to prior art.

As an example, the bed 70 of Figure 2 and/or the bed 9 of Figure 3 is/are polycarbonate shell(s).

70 mm diameter optical lenses of different add power have been coated using the holder disclosed in EP0552607 and the intermediate part of examples 1 to 3. No light diffusing rings or other optical defects were observed on the resulting coated optical lenses.

The intermediate part can also be made of fibrous material, for example but not limited to, made of paper, in particular clean room paper.

The invention has been described above with the aid of embodiments without limitation of the general inventive concept which appears from the claims and the general portion of the specification.

## Claims

1. An optical lens holder (2) for supporting an optical lens (32) during the deposition of a material to form a coating on at least one surface of the optical lens using a material deposition technique, where the optical lens holder (2) comprises a housing (4), a support (8) for the optical lens within the housing comprising first contacting members (14) within a first diameter D₁, the housing having an opening (22) with which a retaining ring (6), comprising second contacting members (30) outer of a second diameter D₂ greater than first diameter D₁, is engageable and said support biased towards said retaining ring so as to press and trap the optical lens in position between the retaining ring and support with at least a portion of a surface of the optical lens exposed for the application of material thereon **characterized in that** an intermediate part (7, 70, 9) is located between the first optical lens contacting members (14) and the optical lens (32) so as to avoid substantially bending of the optical lens, wherein the intermediate part (7) contacts the optical lens (32) in a contacting zone situated on a diameter greater or equal to the second diameter D2.

2. An optical lens holder (2) for supporting an optical lens (32) during the deposition of a material to form a coating on at least one surface of the optical lens using a material deposition technique, where the optical lens holder (2) comprises a housing (4), a support (8) for the optical lens within the housing comprising first contacting members (14) within a first diameter D₁, the housing having an opening (22) with which a retaining ring (6), comprising second contacting members (30) outer of a second diameter D₂ greater than first diameter D₁, is engageable and said support biased towards said retaining ring so as to press and trap the optical lens in position between the retaining ring and support with at least a portion of a surface of the optical lens exposed for the application of material thereon **characterized in that** an intermediate part (7, 70, 9) is located between the first optical lens contacting members (14) and the optical lens (32) so as to avoid substantially bending of the optical lens, wherein the intermediate part (70, 9) contacts the optical lens (32) on a contacting surface of at least 80% of the internal surface of the optical lens (32).

3. The optical lens holder of any of preceding claims where the support (8) comprises a plate (12) with a circular rim (14) as the first contacting members which external diameter is equal to the first diameter D₁.

4. The optical lens holder of any of preceding claims where the second contacting members are a circular rim (30) which internal diameter is equal to the second diameter D₂ and which protrudes inwardly towards the optical lens at an inner edge of the aperture defined by the ring (6) and defines the area of the optical lens surface which is exposed for the application of material thereon.

5. The optical lens holder of claim 1 where the intermediate part is a substantially rigid plate (7) which external periphery substantially fits the internal periphery of the second contacting members (30).

6. The optical lens holder of claims 3 and 5 where the plate (7) is a two-part plate in which a first part (71) substantially fits the internal periphery of the second contacting members (30) and a second part (72) fits the internal periphery of the rim (14) of the first contacting members.

7. The optical lens holder of any of claims 1 to 4 where the intermediate part is a bed (70, 9) comprising at least a surface (73, 91) of external diameter greater than the first diameter D₁ which fits a surface (36, 38) of the optical lens (32) to be coated on and a surface (74, 92) adapted to contact the first contacting members.

8. The optical lens holder of claim 7 where both surfaces (73 and 74, 91 and 92) fits both surfaces (36, 38) of the optical lens (32) to be coated on.

9. The optical lens holder of claim 7 or 8 where the intermediate part (70, 9) is a polycarbonate shell.

10. A method for applying a coating to at least one surface of an optical lens (32) using a material deposition technique, said method including the steps of placing the optical lens (32) in an optical lens holder, where said optical lens holder comprises a housing (4) with a support (8) comprising first contacting members (14) within a first diameter D₁, on which the optical lens is placed, said support biased to urge the optical lens towards an opening (22) defined by a retaining ring (6) comprising second contacting members (30) outer of a second diameter D₂ greater than D₁, said optical lens trapped between the support and retaining ring with the surface to be coated exposed to the material deposition means to allow the layer on the surface to be formed by the deposition of material thereon and the remaining surfaces of the optical lens sealed by the retaining ring to minimise the passage of deposited material onto said other surfaces, **characterized in that** an intermediate part (7, 70, 9) is placed between the first contracting members (14) and the optical lens (32) so as to avoid substantially bending of the optical lens (32), wherein the surface of the optical lens (32) to be coated on is the convex surface (38), and wherein the intermediate part (7) contacts the optical lens (32) in a contacting zone situated on a diameter greater than the second diameter D2.

11. A method for applying a coating to at least one surface of an optical lens (32) using a material deposition technique, said method including the steps of placing the optical lens (32) in an optical lens holder, where said optical lens holder comprises a housing (4) with a support (8) comprising first contacting members (14) within a first diameter D₁, on which the optical lens is placed, said support biased to urge the optical lens towards an opening (22) defined by a retaining ring (6) comprising second contacting members (30) outer of a second diameter D₂ greater than D₁, said optical lens trapped between the support and retaining ring with the surface to be coated exposed to the material deposition means to allow the layer on the surface to be formed by the deposition of material thereon and the remaining surfaces of the optical lens sealed by the retaining ring to minimise the passage of deposited material onto said other surfaces, **characterized in that** an intermediate part (7, 70, 9) is placed between the first contracting members (14) and the optical lens (32) so as to avoid substantially bending of the optical lens (32) and wherein the intermediate part (70, 9) contacts the optical lens (32) on a contacting surface of at least 80% of the internal surface of the optical lens (32).

12. The method of claim 10 where the surface of the optical lens (32) to be coated on is the convex surface (38), where a rigid plate (7) which external periphery substantially fits the internal periphery of the second contacting members (30) is the intermediate part and where the external periphery of the concave surface (36) of the optical lens contacts the rigid plate (7).

13. The method of claim 10 or claim 11 where the surface of the optical lens (32) to be coated on is either the concave (36) in the convex (38) surface of the optical lens, where a bed (70, 9) comprising at least a surface (79, 91) of external diameter greater than the first diameter D₁ and fits respectively at least the convex (38) or concave (36) surface of the optical lens and a surface (74, 92) adapted to contact the first contacting members is the intermediate part.

## Patentansprüche

1. Halter (2) für optische Linsen zum Tragen einer optischen Linse (32) während des Auftragens eines Materials, um eine Beschichtung auf wenigstens einer Oberfläche der optischen Linse mittels einer Materialauftragungstechnik zu bilden, wobei der Halter (2) für optische Linsen umfasst:
ein Gehäuse (4),
einen Träger (8) für die optische Linse innerhalb des Gehäuses, welcher erste Kontaktelemente (14) innerhalb eines ersten Durchmessers D₁ umfasst,
wobei das Gehäuse eine Öffnung (22) aufweist, mit welcher ein Haltering (6) in Eingriff bringbar ist, welcher zweite Kontaktelemente (30) außerhalb eines zweiten Durchmessers D₂ umfasst, welcher größer als der erste Durchmesser D₁ ist, und
wobei der Träger in Richtung des Halterings vorgespannt ist, um die optische Linse mit Druck zu beaufschlagen und in Position zwischen dem Haltering und dem Träger zu klemmen, wobei wenigstens ein Abschnitt einer Oberfläche der optischen Linse für das Auftragen von Material darauf ausgesetzt ist,
**dadurch gekennzeichnet,**
**dass** ein Zwischenteil (7, 70, 9) zwischen den ersten Kontaktelementen (14) für optische Linsen und der optischen Linse (32) angeordnet ist, um ein wesentliches Biegen der optischen Linse zu verhindern,
wobei das Zwischenteil (7) die optische Linse (32) in einer Kontaktzone kontaktiert, welche auf einem Durchmesser liegt, der größer als der oder gleich dem zweiten Durchmesser D₂ ist.

2. Halter (2) für optische Linsen zum Tragen einer optischen Linse (32) während des Auftragens eines Materials, um eine Beschichtung auf wenigstens einer Oberfläche der optischen Linse mittels einer Materialauftragungstechnik zu bilden, wobei der Halter (2) für optische Linsen umfasst:
ein Gehäuse (4),
einen Träger (8) für die optische Linse innerhalb des Gehäuses, welcher erste Kontaktelemente (14) innerhalb eines ersten Durchmessers D₁ umfasst,
wobei das Gehäuse eine Öffnung (22) aufweist, mit welcher ein Haltering (6) in Eingriff bringbar ist, welcher zweite Kontaktelemente (30) außerhalb eines zweiten Durchmessers D₂ umfasst, welcher größer als der erste Durchmesser D₁ ist, und
wobei der Träger in Richtung des Halterings vorgespannt ist, um die optische Linse mit Druck zu beaufschlagen und in Position zwischen dem Haltering und dem Träger zu klemmen, wobei wenigstens ein Abschnitt einer Oberfläche der optischen Linse für das Auftragen von Material darauf ausgesetzt ist,
**dadurch gekennzeichnet,**
**dass** ein Zwischenteil (7, 70, 9) zwischen den ersten Kontaktelementen (14) für optische Linsen und der optischen Linse (32) angeordnet ist, um ein wesentliches Biegen der optischen Linse zu verhindern,
wobei das Zwischenteil (70, 9) die optische Linse (32) auf einer Kontaktoberfläche von ungefähr 80% der inneren Oberfläche der optischen Linse (32) kontaktiert.

3. Halter für optische Linsen nach einem der vorhergehenden Ansprüche, wobei der Träger (8) eine Platte (12) mit einem kreisförmigen Rand (14) als die ersten Kontaktelemente umfasst, dessen externer Durchmesser gleich dem ersten Durchmesser D₁ ist.

4. Halter für optische Linsen nach einem der vorhergehenden Ansprüche, wobei die zweiten Kontaktelemente ein kreisförmiger Rand (30) sind, dessen innerer Durchmesser dem zweiten Durchmesser D₂ gleich ist, und welcher nach innen in Richtung der optischen Linse an einem inneren Rand der durch den Ring (6) definierten Öffnung vorsteht, und den Bereich der Oberfläche der optischen Linse festlegt, welcher für das darauf Auftragen von Material ausgesetzt ist.

5. Halter für optische Linsen nach Anspruch 1,
wobei das Zwischenteil eine im Wesentlichen steife Platte (7) ist, deren äußerer Umfang im Wesentlichen zu dem inneren Umfang der zweiten Kontaktelemente (30) passt.

6. Halter für optische Linsen nach Anspruch 3 und 5,
wobei die Platte (7) eine zweiteilige Platte ist, wobei ein erstes Teil (71) im Wesentlichen zu dem inneren Umfang der zweiten Kontaktelemente (30) passt, und ein zweites Teil (72) zu dem inneren Umfang des Randes (14) der ersten Kontaktelemente passt.

7. Halter für optische Linsen nach einem der Ansprüche 1 bis 4,
wobei das Zwischenteil eine Auflagefläche (70, 9) ist, welche wenigstens eine Oberfläche (73, 91) mit äußerem Durchmesser größer als der erste Durchmesser D₁ umfasst, welche zu einer Oberfläche (36, 38) der optischen Linse (32), die zu beschichten ist, passt, und eine Oberfläche (74, 92) umfasst, die angepasst ist, die ersten Kontaktelemente zu kontaktieren.

8. Halter für optische Linsen nach Anspruch 7,
wobei beide Oberflächen (73 und 74, 91 und 92) zu beiden Oberflächen (36, 38) der optischen Linse (32), welche zu beschichten sind, passen.

9. Halter für optische Linsen nach Anspruch 7 oder 8,
wobei das Zwischenteil (70, 9) eine Polykarbonathülle ist.

10. Verfahren zum Auftragen einer Beschichtung auf wenigstens eine Oberfläche einer optischen Linse (32), mittels einer Materialauftragungstechnik, wobei das Verfahren die Schritte umfasst:
Anordnen der optischen Linse (32) in einem Halter für optische Linsen,
wobei der Halter für optische Linsen ein Gehäuse (4) mit einem Träger (8),
auf welchem die optische Linse angeordnet ist, umfasst, wobei der Träger (8) erste Kontaktelemente (14) innerhalb eines ersten Durchmessers D₁ umfasst,
wobei der Träger vorgespannt wird, um die optische Linse in Richtung einer Öffnung (22) zu drängen, welche durch einen Haltering (6) definiert ist,
welcher zweite Kontaktelemente (30) außerhalb eines zweiten Durchmessers D₂ umfasst, welcher größer als der erste Durchmesser D₁ ist,
wobei die optische Linse zwischen dem Träger und dem Haltering geklemmt wird, wobei die Oberfläche, die zu beschichten ist, den Materialauftragungsmitteln ausgesetzt ist, um die Schicht auf der Oberfläche durch das Auftragen von Material darauf bilden zu können, und
wobei die übrigen Oberflächen der optischen Linse durch den Haltering abgedichtet werden, um den Übergang von Auftragungsmaterial auf die anderen Oberflächen zu minimieren,
**dadurch gekennzeichnet,**
**dass** ein Zwischenteil (7, 70, 9) zwischen den ersten Kontaktelementen (14) und der optischen Linse (32) angeordnet ist, um ein wesentliches Biegen der optischen Linse (32) zu verhindern,
wobei die Oberfläche der optischen Linse (32), die zu beschichten ist, die konvexe Oberfläche (38) ist, und wobei das Zwischenteil (7) die optische Linse (32) in einer Kontaktzone kontaktiert, welche auf einem Durchmesser liegt, der größer als der zweite Durchmesser D₂ ist.

11. Verfahren zum Auftragen einer Beschichtung auf wenigstens eine Oberfläche einer optischen Linse (32), mittels einer Materialauftragungstechnik, wobei das Verfahren die Schritte umfasst:
Anordnen der optischen Linse (32) in einem Halter für optischen Linsen,
wobei der Halter für optische Linsen ein Gehäuse (4) mit einem Träger (8),
auf welchem die optische Linse angeordnet ist umfasst, wobei der Träger (8) erste Kontaktelemente (14) innerhalb eines ersten Durchmessers D₁ umfasst,
wobei der Träger vorgespannt wird, um die optische Linse in Richtung einer Öffnung (22) zu drängen, welche durch einen Haltering (6) definiert ist,
welcher zweite Kontaktelemente (30) außerhalb eines zweiten Durchmessers D₂ umfasst, welcher größer als der erste Durchmesser D₁ ist,
wobei die optische Linse zwischen dem Träger und dem Haltering geklemmt wird, wobei die Oberfläche, die zu beschichten ist, den Materialauftragungsmitteln ausgesetzt ist, um die Schicht auf der Oberfläche durch das Auftragen von Material darauf bilden zu können, und
wobei die übrigen Oberflächen der optischen Linse durch den Haltering abgedichtet werden, um den Übergang von Auftragungsmaterial auf die anderen Oberflächen zu minimieren,
**dadurch gekennzeichnet,**
**dass** ein Zwischenteil (7, 70, 9) zwischen den ersten Kontaktelementen (14) und der optischen Linse (32) angeordnet ist, um ein wesentliches Biegen der optischen Linse (32) zu verhindern,
wobei das Zwischenteil (70, 9) die optische Linse (32) auf einer Kontaktoberfläche von ungefähr 80% der inneren Oberfläche der optischen Linse (32) kontaktiert.

12. Verfahren nach Anspruch 10,
wobei die Oberfläche der optischen Linse (32), die zu beschichten ist, die konvexe Oberfläche (38) ist, wobei eine steife Platte (7), deren äußerer Umfang im Wesentlichen zu dem inneren Umfang der zweiten Kontaktelemente (30) passt, das Zwischenteil ist, und wobei der äußere Umfang der konkaven Oberfläche (36) der optischen Linse die steife Platte (7) kontaktiert.

13. Verfahren nach Anspruch 10 oder Anspruch 11,
wobei die Oberfläche der optischen Linse (32), die zu beschichten ist, entweder die konkave (36) in der konvexen (38) Oberfläche der optischen Linse ist, wobei eine Auflagefläche (70, 9), welche wenigstens eine Oberfläche (79, 91) mit äußerem Durchmesser größer als der erste Durchmesser D₁ umfasst und jeweils wenigstens zu der konvexen (38) oder konkaven (36) Oberfläche der optischen Linse passt, und eine Oberfläche (74, 92) umfasst, welche angepasst ist, die ersten Kontaktelemente zu kontaktieren, das Zwischenteil ist.

## Revendications

1. Porte-lentille optique (2) permettant de supporter une lentille optique (32) pendant le dépôt d'un matériau pour former un revêtement sur au moins une surface de la lentille optique au moyen d'une technique de dépôt de matériau, où le porte-lentille optique (2) comprend un logement (4), un support (8) pour la lentille optique au sein du logement comprenant des premiers organes de contact (14) dans un premier diamètre D₁, le logement comportant une ouverture (22) avec laquelle une bague de retenue (6), comprenant des seconds organes de contact (30) externes d'un second diamètre D₂ plus grand que le premier diamètre D₁, peut être mise en prise et ledit support sollicité vers ladite bague de retenue de façon à presser et piéger la lentille optique dans une position entre la bague de retenue et le support avec au moins une portion d'une surface de la lentille optique exposée pour l'application de matériau sur celle-ci, **caractérisé en ce qu'**une partie intermédiaire (7, 70, 9) est située entre les premiers organes de contact (14) de la lentille optique et la lentille optique (32) de façon à éviter sensiblement une flexion de la lentille optique, où la partie intermédiaire (7) vient en contact avec la lentille optique (32) dans une zone de contact située sur un diamètre supérieur ou égal au second diamètre D₂.

2. Porte-lentille optique (2) permettant de supporter une lentille optique (32) pendant le dépôt d'un matériau pour former un revêtement sur au moins une surface de la lentille optique au moyen d'une technique de dépôt de matériau, où le porte-lentille optique (2) comprend un logement (4), un support (8) pour la lentille optique au sein du logement comprenant des premiers organes de contact (14) dans un premier diamètre D₁, le logement comportant une ouverture (22) avec laquelle une bague de retenue (6), comprenant des seconds organes de contact (30) externes d'un second diamètre D₂ plus grand que le premier diamètre D₁, peut être mise en prise et ledit support sollicité vers ladite bague de retenue de façon à presser et piéger la lentille optique dans une position entre la bague de retenue et le support avec au moins une portion d'une surface de la lentille optique exposée pour l'application de matériau sur celle-ci, **caractérisé en ce qu'**une partie intermédiaire (7, 70, 9) est située entre les premiers organes de contact (14) de la lentille optique et la lentille optique (32) de façon à éviter sensiblement une flexion de la lentille optique, où la partie intermédiaire (70, 9) vient en contact avec la lentille optique (32) sur une zone de contact d'au moins 80 % de la surface interne de la lentille optique (32).

3. Porte-lentille optique selon l'une quelconque des revendications précédentes, dans lequel le support (8) comprend une plaque (12) avec un rebord circulaire (14) en tant que premiers organes de contact, dont le diamètre externe est égal au premier diamètre D₁.

4. Porte-lentille optique selon l'une quelconque des revendications précédentes, dans lequel les seconds organes de contact sont un rebord circulaire (30) dont le diamètre interne est égal au second diamètre D₂ et qui fait saillie vers l'intérieur vers la lentille optique au niveau d'un bord interne de l'ouverture définie par la bague (6) et définit la zone de la surface de la lentille optique qui est exposée pour y appliquer un matériau.

5. Porte-lentille optique selon la revendication 1, dans lequel la partie intermédiaire est une plaque sensiblement rigide (7) dont la périphérie externe s'ajuste sensiblement avec la périphérie interne des seconds organes de contact (30).

6. Porte-lentille optique selon les revendications 3 et 5, dans lequel la plaque (7) est une plaque à deux parties dans laquelle une première partie (71) s'ajuste sensiblement avec la périphérie interne des seconds organes de contact (30) et une seconde partie (72) s'ajuste avec la périphérie interne du rebord (14) des premiers organes de contact.

7. Porte-lentille optique selon l'une quelconque des revendications 1 à 4, dans lequel la partie intermédiaire est un lit (70, 9) comprenant au moins une surface (73, 91) de diamètre externe supérieur au premier diamètre D₁ qui s'ajuste avec une surface (36, 38) de la lentille optique (32) devant être revêtue dessus et une surface (74, 92) adaptée pour venir en contact avec les premiers organes de contact.

8. Porte-lentille optique selon la revendication 7, dans lequel les deux surfaces (73 et 74, 91 et 92) s'ajustent avec les deux surfaces (36, 38) de la lentille optique (32) devant être revêtue dessus.

9. Porte-lentille optique selon la revendication 7 ou 8, dans lequel la partie intermédiaire (70, 9) est une coque en poly(carbonate).

10. Procédé d'application d'un revêtement sur au moins une surface d'une lentille optique (32) au moyen d'une technique de dépôt de matériau, ledit procédé incluant les étapes de placement de la lentille optique (32) dans un porte-lentille optique, où ledit porte-lentille optique comprend un logement (4) avec un support (8) comprenant des premiers organes de contact (14) dans un premier diamètre D₁, sur lequel la lentille optique est placée, ledit support étant sollicité pour pousser la lentille optique vers l'ouverture (22) définie par une bague de retenue (6) comprenant des seconds organes de contact (30) externes d'un second diamètre D₂ plus grand que D₁, ladite lentille optique étant piégée entre le support et la bague de retenue avec la surface devant être revêtue exposée au moyen de dépôt de matériau pour permettre de former la couche sur la surface par le dépôt de matériau par-dessus et les surfaces restantes de la lentille optique obturées par la bague de retenue pour minimiser le passage de matériau déposé sur lesdites autres surfaces, **caractérisé en ce qu'**une partie intermédiaire (7, 70, 9) est placée entre les premiers organes de contact (14) et la lentille optique (32) de façon à éviter sensiblement une flexion de la lentille optique (32), où la surface de la lentille optique (32) devant être revêtue par-dessus est la surface convexe (38), et où la partie intermédiaire (7) vient en contact avec la lentille optique (32) dans une zone de contact située sur un diamètre supérieur au second diamètre D₂.

11. Procédé d'application d'un revêtement sur au moins une surface d'une lentille optique (32) au moyen d'une technique de dépôt de matériau, ledit procédé incluant les étapes de placement de la lentille optique (32) dans un porte-lentille optique, où ledit porte-lentille optique comprend un logement (4) avec un support (8) comprenant des premiers organes de contact (14) dans un premier diamètre D₁, sur lequel la lentille optique est placée, ledit support étant sollicité pour pousser la lentille optique vers l'ouverture (22) définie par une bague de retenue (6) comprenant des seconds organes de contact (30) externes d'un second diamètre D₂ plus grand que D₁, ladite lentille optique étant piégée entre le support et la bague de retenue avec la surface devant être revêtue exposée au moyen de dépôt de matériau pour permettre de former la couche sur la surface par le dépôt de matériau par-dessus et les surfaces restantes de la lentille optique obturées par la bague de retenue pour minimiser le passage de matériau déposé sur lesdites autres surfaces, **caractérisé en ce qu'**une partie intermédiaire (7, 70, 9) est placée entre les premiers organes de contact (14) et la lentille optique (32) de façon à éviter sensiblement une flexion de la lentille optique (32), où la partie intermédiaire (70, 9) vient en contact avec la lentille optique (32) sur une surface de contact d'au moins 80 % de la surface interne de la lentille optique (32).

12. Procédé selon la revendication 10, dans lequel la surface de la lentille optique (32) devant être revêtue dessus est la surface convexe (38), où une plaque rigide (7) dont la périphérie externe s'ajuste sensiblement avec la périphérie interne des seconds organes de contact (30) est la partie intermédiaire et où la périphérie externe de la surface concave (36) de la lentille optique vient en contact avec la plaque rigide (7).

13. Procédé selon la revendication 10 ou la revendication 11, dans lequel la surface de la lentille optique (32) devant être revêtue dessus est soit la surface concave (36), soit la surface convexe (38) de la lentille optique, où un lit (70, 9) comprenant au moins une surface (79, 91) de diamètre externe supérieur au premier diamètre D₁ et qui s'ajuste respectivement au moins avec la surface convexe (38) ou la surface concave (36) de la lentille optique et une surface (74, 92) adaptée pour venir en contact avec les premiers organes de contact est la partie intermédiaire.
